# EUROPÄISCHE PATENTSCHRIFT

(11) **EP 2 193 555 B1**
(45) Veröffentlichungstag und Bekanntmachung des Hinweises auf die Patenterteilung: **06.07.2016**
(21) Anmeldenummer: 08834030.2
(22) Anmeldetag: 27.08.2008
(51) Int. Cl.: H01L 33/40, H01L 33/58, H01L 33/00

(54) **OPTOELEKTRONISCHER HALBLEITERKÖRPER**
OPTO-ELECTRONIC SEMICONDUCTOR BODY
ÉLÉMENT SEMI-CONDUCTEUR OPTOÉLECTRONIQUE

(30) Priorität: 28.09.2007 DE 102007049772; 29.04.2008 DE 102008021403
(43) Veröffentlichungstag der Anmeldung: 09.06.2010
(73) Patentinhaber: OSRAM Opto Semiconductors GmbH, 93055 Regensburg (DE)
(72) Erfinder: RODE, Patrick, 93051 Regensburg (DE); ENGL, Karl, 93080 Niedergebraching (DE); STRASSBURG, Martin, 93105 Tegernheim (DE); HÖPPEL, Lutz, 93087 Alteglofsheim (DE); SABATHIL, Matthias, 93059 Regensburg (DE)
(74) Vertreter: Epping - Hermann - Fischer
(86) Internationale Anmeldenummer: PCT/DE2008/001424
(87) Internationale Veröffentlichungsnummer: WO 2009/039812

(56) Entgegenhaltungen:
- EP-A2- 1 798 780
- WO-A1-2007/037762
- US-A1- 2003 057 444
- US-A1- 2005 221 521
- US-A1- 2006 118 803
- US-B1- 7 053 419
- US-B2- 6 979 584

## Beschreibung

Die vorliegende Erfindung betrifft einen optoelektronischen Halbleiterkörper.

Optoelektronische Halbleiterkörper weisen üblicherweise eine zur Erzeugung von elektromagnetischer Strahlung geeignete aktive Schicht auf. Zum Anlegen einer elektrischen Spannung umfasst der optoelektronische Halbleiterkörper zwei Anschlüsse. Dabei ist häufig ein erster Anschluss an einer ersten Seite der aktiven Schicht und ein zweiter Anschluss an einer zweiten Seite der aktiven Schicht angeordnet. Daher werden eine erste Seite und eine zweite Seite des optoelektronischen Halbleiterkörpers kontaktiert.

Aufgabe der Erfindung ist es, einen verbesserten optoelektronischen Halbleiterkörper bereitzustellen. US-B1-6 979 584 offenbart einen optoelektronischen Halbleiterkörper gemäß dem Oberbegriff von Anspruch 1.

Diese Aufgabe wird mit dem Gegenstand mit den Merkmalen des Patentanspruchs 1 gelöst. Weiterbildungen und Ausgestaltungen sind jeweils Gegenstand der abhängigen Ansprüche.

In einer Ausführungsform umfasst ein optoelektronischer Halbleiterkörper ein Substrat mit einer Vorderseite und einer Rückseite. Die Vorderseite des Substrats ist zur Emission von elektromagnetischer Strahlung vorgesehen. Weiter weist der optoelektronische Halbleiterkörper eine Halbleiterschichtenfolge sowie eine erste und eine zweite elektrische Anschlussschicht auf. Die Halbleiterschichtenfolge ist auf, insbesondere an, der Rückseite des Substrats angeordnet. Die Halbleiterschichtenfolge weist eine zur Erzeugung der elektromagnetischen Strahlung geeignete aktive Schicht auf. Die erste und die zweite elektrische Anschlussschicht sind auf, insbesondere an, einer ersten Fläche der Halbleiterschichtenfolge angeordnet, die vom Substrat abgewandt ist.

Die Rückseite des Substrats kann die Unterseite des Substrats sein. Die Unterseite des Substrats kann diejenige Seite des Substrats sein, die bei der Montage des Halbleiterkörpers einem Anschlussleiter zugewandt ist. Die Vorderseite des Substrats kann die Oberseite des Substrats sein.

Die Halbleiterschichtenfolge kann epitaktisch gewachsen sein. Die Halbleiterschichtenfolge kann epitaktisch auf dem Substrat abgeschieden sein.

Da die beiden elektrischen Anschlussschichten sich an der vom Substrat abgewandten ersten Fläche der Halbleiterschichtenfolge befinden, kann eine Emission der elektromagnetischen Strahlung über eine Vorderseite des optoelektronischen Halbleiterkörpers und die Zuführung von elektrischer Energie zur aktiven Schicht über eine Rückseite des optoelektronischen Halbleiterkörpers ermöglicht sein. Somit behindern die beiden elektrischen Anschlussschichten die Strahlungsauskopplung über die Vorderseite nicht, so dass eine hohe Auskoppeleffizienz erzielt wird. Bevorzugt bildet die Vorderseite des Substrats eine Vorderseite des optoelektronischen Halbleiterkörpers. Hingegen können die beiden elektrischen Anschlussschichten eine Rückseite des optoelektronischen Halbleiterkörpers bilden.

Das Substrat kann ein gitterangepasstes Substrat sein. Dabei ist es an ein Kristallgitter der Halbleiterschichtenfolge angepasst. Dies vereinfacht eine epitaktische Abscheidung der Halbleiterschichtenfolge auf dem Substrat. Das Substrat ist insbesondere an eine erste Schicht der Halbleiterschichtenfolge gitterangepasst, die auf der Rückseite des Substrats abgeschieden ist.

In einer Ausführungsform enthält der Halbleiterkörper, beispielsweise das Substrat und/oder die Halbleiterschichtenfolge, einen Nitrid-Verbindungshalbleiter. Einen Nitrid-Verbindungshalbleiter zu enthalten, kann bedeuten, dass der Halbleiterkörper, insbesondere das Substrat und/oder die Halbleiterschichtenfolge, ein NitridIII-Verbindungshalbleitermaterial, vorzugsweise AlₙGaₘIn₁₋ₙ₋ₘN umfasst, wobei 0 ≤ n ≤ 1, 0 ≤ m ≤ 1 und n+m ≤ 1. Dabei muss dieses Material nicht zwingend eine mathematisch exakte Zusammensetzung nach obiger Formel aufweisen. Vielmehr kann es einen oder mehrere Dotierstoffe sowie zusätzliche Bestandteile aufweisen, die die charakteristischen physikalischen Eigenschaften des AlₐGaₘIn₁₋ₙ₋ₘN-Materials im Wesentlichen nicht ändern. Der Einfachheit halber beinhaltet obige Formel jedoch nur die wesentlichen Bestandteile des Kristallgitters Al, Ga, In, N, auch wenn diese teilweise durch geringe Mengen weiterer Stoffe ersetzt sein können.

In einer Ausführungsform enthält das Substrat einen ersten Nitrid-Verbindungshalbleiter. Die Halbleiterschichtenfolge enthält einen zweiten Nitrid-Verbindungshalbleiter.

In einer Ausführungsform sind der erste und der zweite Nitrid-Verbindungshalbleiter unterschiedlich. In einer alternativen Ausführungsform sind der erste und der zweite Nitrid-Verbindungshalbleiter gleich. Durch die Verwendung eines Nitrid-Verbindungshalbleiters sowohl für das Substrat wie auch für die Halbleiterschichtenfolge ist das Substrat an die Halbleiterschichtenfolge gut gitterangepasst.

Das Substrat kann kristallines Galliumnitrid GaN enthalten. Bevorzugt ist das Substrat als Galliumnitrid-Einkristall ausgebildet. Durch die Abscheidung einer Galliumnitridbasierten Epitaxieschicht auf das Galliumnitrid enthaltende Substrat kann ein Brechungsindexsprung zwischen Substrat und Halbleiterschichtenfolge gering gehalten oder vermieden sein. Ein Wellenleitereffekt an der Rückseite des Substrats kann so vermindert oder vermieden werden. Durch das homoepitaktische Abscheiden wird die Anzahl von Versetzungen in der Halbleiterschichtenfolge minimiert. Eine Versetzungsdichte kann beispielsweise deutlich kleiner als 10⁷ Versetzungen pro Quadratzentimeter sein.

In einer alternativen Ausführungsform umfasst das Substrat einen Hilfsträger, vorzugsweise einen kristallinen Hilfsträger, der vorderseitig im Substrat, insbesondere an der Vorderseite des Substrats, angeordnet ist. Die Halbleiterschichtenfolge enthält einen Nitrid-Verbindungshalbleiter. Bevorzugt ist der Nitrid-Verbindungshalbleiter als ein Aluminiumindiumgalliumnitrid-Verbindungshalbleiter gemäß obiger Formel realisiert. Die Halbleiterschichtenfolge ist heteroepitaktisch auf der Rückseite des Substrats abgeschieden. Der Hilfsträger kann kristallin sein. Der Hilfsträger kann als Aufwachssubstrat ausgebildet sein. Bevorzugt kann der Hilfsträger ein Material enthalten, das sich von einem auf einem Nitrid-Verbindungshalbleiter basierten Material der Halbleiterschichtenfolge unterscheidet. Durch die Verwendung des Hilfsträgers ist eine kosteneffektive Herstellung des optoelektronischen Halbleiterkörpers erleichtert.

In einer Weiterbildung umfasst der Hilfsträger kristallines Aluminiumoxid Al₂O₃. Bevorzugt ist der Hilfsträger als Aluminiumoxid-Einkristall realisiert. Ein Aluminiumoxid-Einkristall wird üblicherweise als Saphir bezeichnet.

In einer Weiterbildung ist die Rückseite des Substrats derart realisiert, dass die Auswirkungen eines Unterschiedes der Brechungsindizes des Hilfsträgers und der Halbleiterschichtenfolge verringert werden. Dadurch ist die Strahlungsausbeute weiter erhöht.

In einer Weiterbildung ist eine erste Hauptfläche des Hilfsträgers vorstruktüriert. Die erste Hauptfläche des Hilfsträgers ist der Halbleiterschichtenfolge zugewandt und damit der Vorderseite des Substrats abgewandt. Ein derart vorstrukturiertes Substrat, englisch pre patterned substrate, abgekürzt PPS, kann eine epitaktische Abscheidung der Halbleiterschichtenfolge erleichtern.

In einer Ausführungsform kann das Substrat eine Nukleationsschicht aufweisen, die auf der ersten Hauptfläche des Hilfsträgers angeordnet und insbesondere abgeschieden ist. Die Nukleationsschicht kann als strukturierte Nukleationsschicht ausgebildet sein. Die strukturierte Nukleationsschicht kann laterale Strukturen mit Abmessungen in einem Intervall zwischen 5 nm und 100 nm aufweisen. Bevorzugt umfasst die strukturierte Nukleationsschicht Strukturen mit lateralen und vertikalen Abmessungen in einem Intervall zwischen 5 nm und 100 nm. Ein typischer Wert für eine Abmessung ist 30 nm. Die Nukleationsschicht kann ein Metall enthalten. Aufgrund der geringen Dimensionen der Nukleationsschicht können Oberflächenplasmonen in der Nukleationsschicht auftreten.

In einer Weiterbildung umfasst das Substrat eine Pufferschicht, die auf der ersten Hauptfläche des Hilfsträgers angeordnet und insbesondere abgeschieden ist. Die Pufferschicht kann gegebenenfalls auf der Nukleationsschicht angeordnet und insbesondere abgeschieden sein. Die Pufferschicht kann eine dielektrische Schicht enthalten. Die dielektrische Schicht kann Siliziumoxid oder Siliziumnitrid, abgekürzt SiO_{X} beziehungsweise SiN_{X}, enthalten. Alternativ oder ergänzend enthält die Pufferschicht Aluminiumgalliumnitrid und/oder Galliumnitrid. Die Pufferschicht kann einen Aluminiumgalliumnitrid-Galliumnitrid-Übergang, abgekürzt AlGaN-GaN-Übergang, aufweisen. Der AlGaN-GaN-Übergang kann epitaktisch abgeschieden werden. Die Pufferschicht kann eine Rückseite des Substrats bilden, welche an die Halbleiterschichtenfolge angepasst ist, sodass eine Halbleiterschichtenfolge epitaktisch abgeschieden werden kann und eine hohe Strahlungsausbeute erzielt wird.

In einer Weiterbildung ist die Pufferschicht strukturiert. Die vertikalen und lateralen Abmessungen der Pufferschicht können dabei in einem Intervall zwischen 5 nm und 5 µm liegen. Bevorzugt sind die lateralen und vertikalen Abmessungen der Pufferschicht aus einem Intervall zwischen 60 nm und 500 nm. Die Pufferschicht kann eine Aufraustruktur aufweisen. Die Aufraustruktur kann unregelmäßig sein. Optional ist die Pufferschicht als periodische Gitterstruktur realisiert.

In einer Weiterbildung ist die Halbleiterschichtenfolge oder eine erste Schicht der Halbleiterschichtenfolge mittels des Verfahrens der Strukturierung der Epitaxie auf der Rückseite des Substrats abgeschieden. Dazu können beispielsweise der Hilfsträger, die Nukleationsschicht und/oder die Pufferschicht eine Struktur aufweisen. Die erste Schicht der Halbleiterschichtenfolge ist auf der Rückseite des Substrats angeordnet. Die erste Schicht kann optional strukturiert sein. Mittels Strukturierung der Epitaxie können Strukturen mit lateralen und vertikalen Abmessungen in einem Intervall zwischen 5 nm und 5 µm realisiert werden. Die erste Schicht kann als Aufraustruktur oder als periodische Gitterstruktur realisiert sein. Bevorzugt sind die lateralen und/oder vertikalen Abmessungen der Strukturen in einem Intervall zwischen 60 nm und 500 nm. Das Verfahren der Strukturierung der Epitaxie kann als Verfahren der strukturierten Epitaxie oder Verfahren der selektiven Epitaxie oder Verfahren des epitaktischen Überwachsens ausgebildet sein. Das Verfahren des epitaktischen Überwachsens wird im Englischen als epitaxial lateral over growth, abgekürzt ELOG, bezeichnet. Bei dem ELOG-Verfahren beginnt die epitaktische Abscheidung an einzelnen Stellen auf dem Substrat. Die anfänglich nur inselförmig vorhandene epitaktische Schicht schließt sich im Verlauf des epitaktischen Verfahrens zu einer geschlossenen epitaktischen Schicht zusammen, welche die erste Schicht bildet. Dabei werden die Zwischenräume zwischen den Stellen, an denen das Wachstum der epitaktischen Schicht begonnen hat, überwachsen. Die Zwischenräume, die lateral überwachsen werden, können durch eine strukturierte Maskenschicht gebildet sein. Somit weist die epitaktische Schicht zumindest substratseitig eine Struktur auf.

Mittels der aufgeführten Ausführungsformen des Substrats mit Hilfsträger wird eine Gitteranpassung zwischen einem Gitter des Hilfsträgers und einem Gitter der Halbleiterschichtenfolge erreicht. Somit wird eine Höhe der bei Gitterfehlanpassungen ansonsten auftretenden Versetzungsdichte reduziert. Derartige Versetzungen können als Zentren nicht strahlender Rekombination wirken. Durch das Vermeiden der Versetzungen wird die Effizienz des optoelektronischen Halbleiterkörpers erhöht. Zusätzlich können die Auswirkungen eines Brechungsindexunterschieds zwischen dem Hilfsträger und der Halbleiterschichtenfolge reduzierbar sein. Die Rückseite des Substrates kann derart ausgebildet sein, dass ein Brechungsindex des Hilfsträgers an einen Brechungsindex der Halbleiterschichtenfolge angepasst ist.

In einer Ausführungsform umfasst der optoelektronische Halbleiterkörper eine Auskoppelstruktur. Die Auskoppelstruktur ist an der Vorderseite des Substrats angeordnet. Die Auskoppelstruktur kann Schichten umfassen, die auf die Vorderseite des Substrats aufgebracht sind.

In einer Weiterbildung umfasst das Substrat die Auskoppelstruktur. Gemäß der Weiterbildung ist die Auskoppelstruktur im Substrat realisiert. Somit erfolgt die Emission der elektromagnetischen Strahlung von der Vorderseite des Substrats durch die Auskoppelstruktur, sodass die Winkelabhängigkeit der Stärke der elektromagnetischen Strahlung eingestellt werden kann.

In einer bevorzugten Weiterbildung wird ein Nitrid-Verbindungshalbleiter, insbesondere Galliumnitrid, für das die Auskoppelstruktur umfassende Substrat verwendet. Die für die Auskoppelstruktur erforderlichen Strukturen, insbesondere Ausnehmungen, können in das Substrat geätzt werden. Die Auskoppelstruktur kann im Substrat effizient hergestellt werden, da ein Nitrid-Verbindungshalbleiter durch trockenchemisches oder nasschemisches Ätzen einfach strukturiert werden kann.

In einer Weiterbildung umfasst der optoelektronische Halbleiterkörper einen Spiegel, insbesondere eine dielektrischen Spiegel, welcher an der vom Substrat abgewandten ersten Fläche der Halbleiterschichtenfolge angeordnet ist. Bevorzugt ist der Spiegel zwischen der Halbleiterschichtenfolge und der ersten und/oder der zweiten elektrischen Anschlussschicht zumindest bereichsweise angeordnet. Mittels des Spiegels wird ein Anteil der von der aktiven Schicht emittierten elektromagnetischen Strahlung in Richtung der Vorderseite des Substrats gespiegelt. Somit ist die Strahlungsauskopplung erhöht.

In einer Ausführungsform weist der Spiegel eine dielektrische Schicht und eine Metallschicht auf. Die dielektrische Schicht wird auf die Halbleiterschichtenfolge abgeschieden. Die dielektrische Schicht kann beispielsweise Siliziumoxid oder Siliziumnitrid, abgekürzt SiO_{X} beziehungsweise SiN_{X}, enthalten. Die Metallschicht dient als Reflektor. Die Metallschicht kann Aluminium Al, Silber Ag, Platin Pt, Titan Ti, Titanwolfram TiW, Titanwolframnitrid TiWN oder eine Legierung enthalten. Bevorzugt enthält die Legierung eines der genannten Metalle beziehungsweise Metallverbindungen.

In einer Weiterbildung weisen die dielektrische Schicht und die Metallschicht zumindest eine Ausnehmung auf, sodass die erste und/oder die zweite elektrische Anschlussschicht in der zumindest einen Ausnehmung auf einer Schicht der Halbleiterschichtenfolge angeordnet sind. Somit ist ein elektrisch leitender Kontakt der ersten und/oder der zweiten elektrischen Anschlussschicht zu der Halbleiterschichtenfolge erzielt. Dadurch wird eine Durchkontaktierung durch den Spiegel hergestellt.

Zwischen der dielektrischen Schicht und der Metallschicht des Spiegels kann eine Haftvermittlungsschicht angeordnet sein. Die Haftvermittlungsschicht kann ein Metall, wie beispielsweise Platin, Titan, Titanwolfram oder Titanwolframnitrid, enthalten. Eine Dicke der Haftvermittlungsschicht kann kleiner oder gleich 5 nm, bevorzugt kleiner oder gleich 1 nm sein. Titanwolfram und Titanwolframnitrid sind zusätzlich auch als Diffusionssperre einsetzbar. Platin weist sowohl gute Eigenschaften als Diffusionssperre wie auch als Reflektor auf.

In einer Ausführungsform umfassen die erste und/oder die zweite elektrische Anschlussschicht einen Mehrschichtaufbau.

In einer Weiterbildung umfassen die erste und/oder die zweite elektrische Anschlussschicht ein transparentes leitfähiges Oxid. Transparente leitfähige Oxide, englisch transparent conductive oxides, abgekürzt TCO, sind transparente, elektrisch leitende Materialien, in der Regel Metalloxide, wie beispielsweise Zinkoxid, Zinnoxid, Cadmiumoxid, Titanoxid, Indiumoxid, Indiumzinkoxid oder Indiumzinnoxid, abgekürzt ITO. Neben binären Metallsauerstoffverbindungen, wie beispielsweise ZnO, SnO₂ oder In₂O₃ gehören auch ternäre Metallsauerstoffverbindungen, wie beispielsweise Zn₂SnO₄, CdSnO₃, ZnSnO₃, MgIn₂O₄, GaInO₃, Zn₂In₂O₅ oder In₄Sn₃O₁₂ oder Mischungen unterschiedlicher transparenter leitfähiger Oxide zu der Gruppe der TCOs. Weiterhin entsprechen die TCOs nicht zwingend einer stöchiometrischen Zusammensetzung und können auch p- oder n-dotiert sein. Bevorzugt kann ein derartiges transparentes leitfähiges Oxid Indiumzinnoxid oder Indiumzinkoxid enthalten. Mittels der transparenten leitfähigen Oxidschicht wird eine Stromaufweitung der ersten und/oder der zweiten elektrischen Anschlussschicht erzielt.

Der optoelektronische Halbleiterkörper kann als Leuchtdiode, insbesondere als Dünnfilm-Leuchtdioden-Chip, realisiert sein, und die elektromagnetische Strahlung kann insbesondere sichtbares Licht sein.

In einer Ausführungsform umfasst ein Verfahren zur Herstellung eines optoelektronischen Halbleiterkörpers das Bereitstellen eines Substrats, das eine Vorderseite zur Emission von elektromagnetischer Strahlung und eine Rückseite umfasst. Eine Halbleiterschichtenfolge wird epitaktisch auf der Rückseite des Substrats abgeschieden. Die Halbleiterschichtenfolge umfasst eine zur Erzeugung der elektromagnetischen Strahlung geeignete aktive Schicht. Eine erste und eine zweite elektrische Anschlussschicht werden an einer dem Substrat abgewandten ersten Fläche der Halbleiterschichtenfolge abgeschieden.

Bevorzugt ist der optoelektronische Halbleiterkörper als einseitig kontaktierbarer optoelektronischer Halbleiterkörper realisiert. Aufgrund der Kontaktierung von einer Rückseite des optoelektronischen Halbleiterkörpers her ist die Strahlungsauskopplung auf einer Vorderseite des optoelektronischen Halbleiterkörpers sehr effizient. Der optoelektronische Halbleiterkörper kann somit in Flipchip-Technik auf einem Trägerkörper, wie beispielsweise einer Leiterplatte oder einem Gehäuse, aufgebracht werden.

Die Erfindung wird nachfolgend an mehreren Ausführungsbeispielen anhand der Figuren näher erläutert. Funktionsbeziehungsweise wirkungsgleiche Schichten, Gebiete und Strukturen tragen gleiche Bezugszeichen. Insoweit sich Schichten, Gebiete oder Strukturen in ihrer Funktion entsprechen, wird deren Beschreibung nicht in jeder der folgenden Figuren wiederholt.

Es zeigen:
- Figuren 1A und 1B: beispielhafte Ausführungsformen eines optoelektronischen Halbleiterkörpers nach dem vorgeschlagenen Prinzip und
- Figuren 2A bis 2D: weitere beispielhafte Ausführungsformen eines optoelektronischen Halbleiterkörpers mit einer Auskoppelstruktur nach dem vorgeschlagenen Prinzip,
- Figuren 3A bis 3C: beispielhafte Ausführungsformen eines optoelektronischen Halbleiterkörpers mit einer strukturierten Nukleationsschicht nach dem vorgeschlagenen Prinzip,
- Figuren 4A bis 4C: beispielhafte Ausführungsformen eines optoelektronischen Halbleiterkörpers mit einer strukturierten Pufferschicht nach dem vorgeschlagenen Prinzip und
- Figuren 5A bis 5C: weitere beispielhafte Ausführungsformen eines optoelektronischen Halbleiterkörpers mit einem strukturierten Substrat nach dem vorgeschlagenen Prinzip.

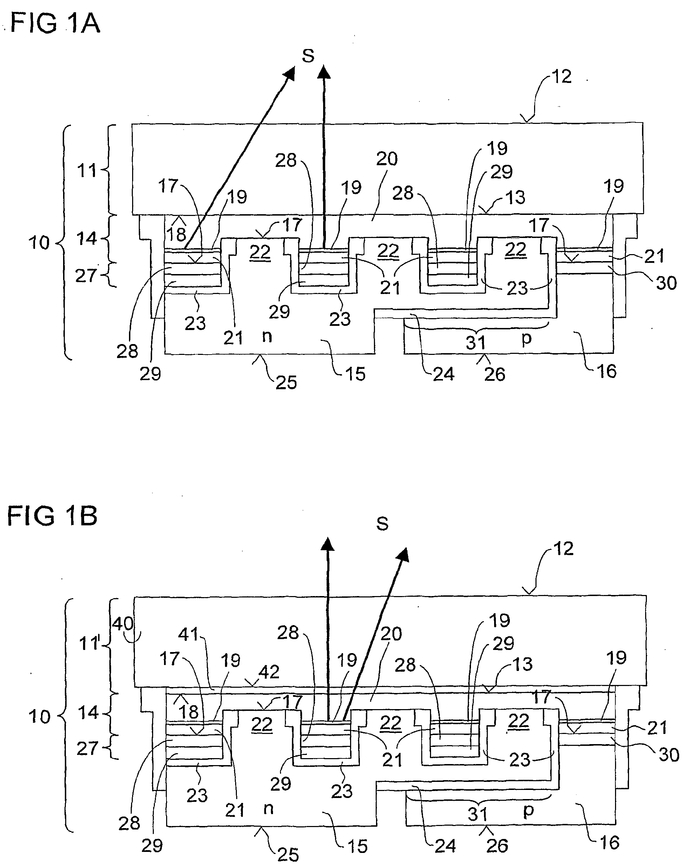

Figur 1A zeigt eine beispielhafte Ausführungsform eines optoelektronischen Halbleiterkörpers nach dem vorgeschlagenen Prinzip. Der optoelektronische Halbleiterkörper 10 umfasst ein Substrat 11 mit einer Vorderseite 12 und einer Rückseite 13. Weiter umfasst der optoelektronische Halbleiterkörper 10 eine Halbleiterschichtenfolge 14 sowie eine erste und eine zweite elektrische Anschlussschicht 15, 16. Die Halbleiterschichtenfolge 14 ist auf der Rückseite 13 des Substrats 11 angeordnet. Die Halbleiterschichtenfolge 14 weist eine erste und eine zweite Fläche 17, 18 auf. Die erste Fläche 17 der Halbleiterschichtenfolge 14 ist dem Substrat 11 abgewandt. Hingegen ist die zweite Fläche 18 der Halbleiterschichtenfolge 14 auf der Rückseite 13 des Substrats 11 angeordnet. Die erste und die zweite elektrische Anschlussschicht 15, 16 sind an der ersten Fläche 17 der Halbleiterschichtenfolge 14 angeordnet. Darüber hinaus umfasst die Halbleiterschichtenfolge 14 eine aktive Schicht 19, mindestens eine n-leitende Schicht 20 und mindestens eine p-leitende Schicht 21. Dabei ist die mindestens eine n-leitende Schicht 20 zwischen der aktiven Schicht 19 und dem Substrat 11 beziehungsweise zwischen der aktiven Schicht 19 und der zweiten Fläche 18 der Halbleiterschichtenfolge 14 angeordnet. Die mindestens eine p-leitende Schicht 21 ist zwischen der aktiven Schicht 19 und der ersten Fläche 17 der Halbleiterschichtenfolge 14 angeordnet.

Die Rückseite 13 des Substrats 11 kann die Unterseite des Substrats 11 sein. Die Unterseite des Substrats 11 kann diejenige Seite des Substrats 11 sein, die bei der Montage des Halbleiterkörpers 10 einem Anschlussleiter zugewandt ist. Die Vorderseite 12 des Substrats 11 kann die Oberseite des Substrats 11 sein.

Die p-leitende Schicht 21 und die aktive Schicht 19 umfassen mehrere Ausnehmungen 22. Die Ausnehmungen 22 sind für die Verbindung der ersten Anschlussschicht 15 zu der n-leitenden Schicht 20 vorgesehen. Die erste Anschlussschicht 15 weist mehrere elektrisch leitende Kontakte zu der n-leitenden Schicht 20 auf. In Figur 1A sind drei Kontakte der ersten elektrischen Anschlussschicht 15 zu der n-leitenden Schicht 20 gezeigt. Weiter weist die zweite elektrische Anschlussschicht 16 einen Kontakt zu der p-leitenden Schicht 21 auf. An den Seitenwänden der Ausnehmungen 22 und bereichsweise auf der p-leitenden Schicht 21 ist eine erste Isolatorschicht 23 angeordnet. Die erste elektrische Anschlussschicht 15 ist auf der n-leitenden Schicht 20 in den Ausnehmungen 22 und auf der ersten Isolatorschicht 23 abgeschieden. Bereichsweise ist auf der ersten elektrischen Anschlussschicht 15 eine zweite Isolatorschicht 24 angeordnet. Die zweite elektrische Anschlussschicht 16 ist bereichsweise auf der zweiten Isolatorschicht 24 und auf der p-leitenden Schicht 21 angeordnet. In einem Bereich 31 ist die erste Anschlussschicht 15 zwischen der Halbleiterschichtenfolge 14 und der zweiten Anschlussschicht 16 angeordnet. In dem Bereich 31 ist die erste Anschlussschicht 15 von der zweiten Anschlussschicht 16 über die zweite Isolatorschicht 24 elektrisch isoliert.

Die erste und die zweite elektrische Anschlussschicht 15, 16 weisen eine erste und eine zweite Anschlussfläche 25, 26 auf. Die erste und die zweite Anschlussfläche 25, 26 sind näherungsweise in einer Ebene angeordnet. Die beiden Anschlussflächen 25, 26 sind näher zu der ersten Fläche 17 als zu der zweiten Fläche 18 der Halbleiterschichtenfolge 14 angeordnet. Zwischen der p-leitenden Schicht 21 und der ersten Isolatorschicht 23 ist ein Spiegel 27 angeordnet. Der Spiegel 27 umfasst eine dielektrische Schicht 28 und eine Metallschicht 29. Die dielektrische Schicht 28 ist bereichsweise auf der ersten Fläche 17 der Halbleiterschichtenfolge 14 abgeschieden. Die Metallschicht 29 wiederum ist auf der dielektrischen Schicht 28 angeordnet. Die zweite elektrische Anschlussschicht 16 enthält in einem Bereich, in dem sie auf der p-leitenden Schicht 21 angeordnet ist, ein transparentes leitfähiges Oxid 30. Das transparente leitfähige Oxid 30 ist als Schicht ausgebildet. Das Substrat 11 enthält ein kristallines Galliumnitrid. Das Substrat 11 ist als Galliumnitrid-Einkristall realisiert. Die Halbleiterschichtenfolge 14 enthält einen Nitrid-Verbindungshalbleiter. Die Halbleiterschichtenfolge 14 weist einen Galliumnitrid- oder einen Indiumgalliumnitrid-Verbindungshalbleiter auf.

Die erste und die zweite elektrische Anschlussschicht 15, 16 sind von einer Rückseite des optoelektronischen Halbleiterkörpers 10 kontaktierbar. Mittels der ersten elektrischen Anschlussschicht 15 und der n-leitenden Schicht 20 sowie der zweiten elektrischen Anschlussschicht 16 und der p-leitenden Schicht 21 wird eine elektrische Spannung an die aktive Schicht 19 angelegt. Die über die aktive Schicht 19 abfallende Spannung generiert eine elektromagnetische Strahlung S, die zu einem ersten Anteil durch die n-leitende Schicht 20 und das Substrat 11 hindurch tritt und an der Vorderseite 12 des Substrats 11 emittiert wird. Ein zweiter Anteil der elektromagnetischen Strahlung wird von der aktiven Schicht 19 in Richtung der ersten Fläche 17 der Halbleiterschichtenfolge 14 emitiert. Ein Teil des zweiten Anteils der elektromagnetischen Strahlung wird dort von dem Spiegel 27 reflektiert, sodass dieser Teil auch an der Vorderseite 12 des Substrats 11 austritt.

Die n-leitende Schicht 20 ist über die mehreren Ausnehmungen 22 mehrfach kontaktiert, sodass eine niederohmige Verbindung von der ersten Anschlussfläche 25 zur n-leitenden Schicht 20 erzielt ist. Mittels der Durchkontaktierungen durch die p-leitende Schicht 21 ist erzielt, dass die erste und die zweite Anschlussfläche 25, 26 auf der von dem Substrat 11 abgewandten Rückseite des optoelektronischen Halbleiterkörpers 10 angeordnet sind, sodass sie einfach auf einen nicht gezeigten Träger, beispielsweise einem Gehäuse, aufgesetzt werden können. Somit kann ein Strahlungsaustritt auf der Vorderseite 12 ohne Behinderung von einem etwaigen elektrischen Anschluss des optoelektronischen Halbleiterkörpers 10 zu einem Gehäuse erfolgen, sodass die Strahlungsausbeute erhöht ist und der optoelektronische Halbleiterkörper 10 kosteneffektiv gehäust werden kann. Mittels des Spiegels 27 ist die Strahlungsausbeute weiter verbessert.

Figur 1B zeigt eine weitere beispielhafte Ausführungsform eines optoelektronischen Halbleiterkörpers nach dem vorgeschlagenen Prinzip. Die Halbleiterschichtenfolge 14, die erste und die zweite elektrische Anschlussschicht 15, 16, die erste und die zweite Isolatorschicht 23, 24, der Spiegel 27 sowie das transparente leitfähige Oxid 30 sind wie in Figur 1A gezeigt realisiert. Im Unterschied zu der in Figur 1A gezeigten Ausführungsform weist das Substrat 11' des optoelektronischen Halbleiterkörpers 10 gemäß Figur 1B einen Hilfsträger 40 auf. Der Hilfsträger 40 ist an der Vorderseite 12 des Substrats 11 angeordnet. Der Hilfsträger 40 ist als kristalliner Hilfsträger ausgebildet. Der Hilfsträger 40 enthält kristallines Aluminiumoxid. Weiter umfasst das Substrat 11' eine Pufferschicht 41, die zwischen dem Hilfsträger 40 und der Rückseite 13 des Substrats 11' angeordnet ist. Die Pufferschicht 41 kann auch als Auskoppelschicht realisiert sein. Die Pufferschicht 41 enthält Aluminiumgalliumnitrid oder Galliumnitrid. Die Pufferschicht 41 ist auf einer ersten Hauptfläche 42 des Hilfsträgers 40 angeordnet. Die erste Hauptfläche 42 ist die der Halbleiterschichtenfolge 14 zugewandte Hauptfläche des Hilfsträgers 40.

Das Substrat 11' und der Hilfsträger 40 sind transparent für die elektromagnetische Strahlung S. Mittels der Pufferschicht 41 ist das Substrat 11' an die Halbleiterschichtenfolge 14 angepasst. Somit wird die Auswirkung eines Brechungsindexsprungs zwischen der Halbleiterschichtenfolge 14 und dem Substrat 11' verringert, sodass die Strahlungsausbeute an der Vorderseite 12 hoch ist. Weiter erfolgt mit der Pufferschicht 41 eine Anpassung der Kristallgitterkonstanten des Hilfsträgers 40 an die Kristallgitterkonstanten der Halbleiterschichtenfolge 14, sodass eine Versetzungsdichte erniedrigt und damit ebenfalls die Strahlungsausbeute erhöht ist.

Der Hilfsträger 40 ist bevorzugt als Aluminiumoxid-Einkristall ausgebildet.

In einer alternativen Ausführungsform enthält die Pufferschicht 41 eine dielektrische Schicht. Die dielektrische Schicht kann beispielsweise Siliziumoxid oder Siliziumnitrid enthalten.

In einer nicht gezeigten, alternativen Ausführungsform kann auf der ersten Hauptfläche 42 anstelle der Pufferschicht 41 eine Nukleationsschicht aufgebracht sein. Dabei kann die Nukleationsschicht eine erste monokristalline Fläche bilden.

In einer nicht gezeigten, alternativen Ausführungsform kann eine Nukleationsschicht zwischen dem Hilfsträger 40 und der Pufferschicht 41 angeordnet sein. Die Pufferschicht 41 kann dabei die Gitteranpassung der Nukleationsschicht an die Halbleiterschichtenfolge 14 erleichtern.

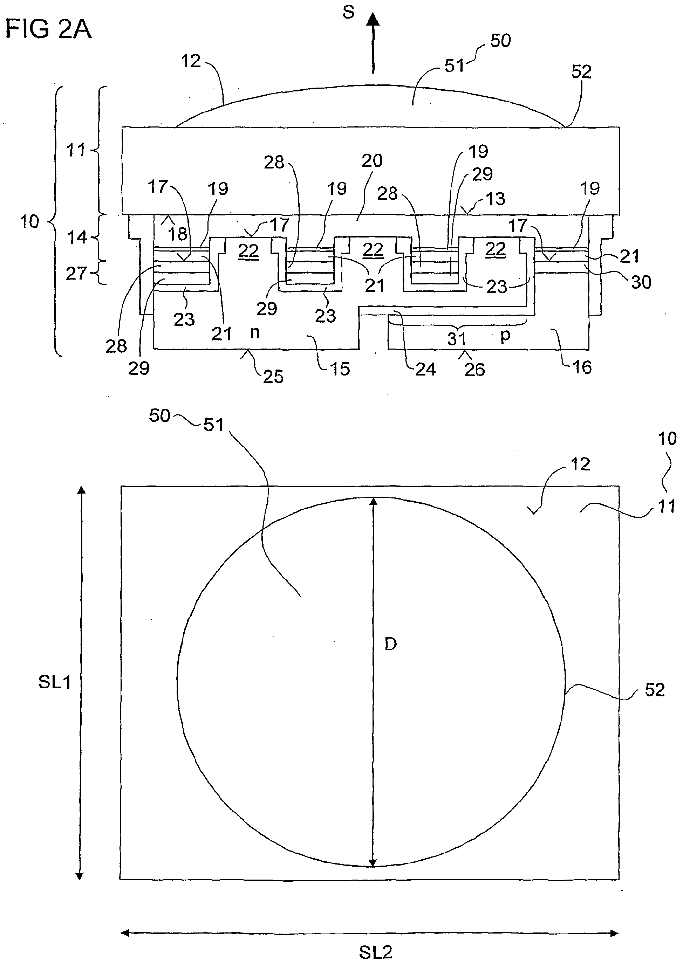

Figuren 2A bis 2D zeigen insgesamt vier beispielhafte Ausführungsformen eines optoelektronischen Halbleiterkörpers mit unterschiedlichen Auskoppelstrukturen nach dem vorgeschlagenen Prinzip. Die in den Figuren 2A bis 2D gezeigten Ausführungsformen sind eine Weiterbildung der in den Figuren 1A und 1B dargestellten Ausführungsformen. Die Halbleiterschichtenfolge 14, die erste und die zweite elektrische Anschlussschicht 15, 16, die erste und die zweite Isolatorschicht 23, 24, der Spiegel 27 sowie das transparente leitfähige Oxid der in den Figuren 2A bis 2D gezeigten Ausführungsformen entsprechen den entsprechenden Schichten in Figur 1A sowie 1B und sind somit im Folgenden nicht näher erläutert.

In den Figuren 2A bis 2D sind jeweils ein Querschnitt und eine Aufsicht auf die Vorderseite 12 des Substrats 11 gezeigt. Das Substrat 11 ist in der Aufsicht als Rechteck ausgebildet. Gemäß Figuren 2A bis 2D umfasst das Substrat 11 jeweils eine Auskoppelstruktur 50. Die Auskoppelstruktur 50 ist im Substrat 11 ausgebildet.

Gemäß Figur 2A ist die Auskoppelstruktur 50 als Mikrolinse 51 realisiert. Die Mikrolinse 51 ist durch eine Kreislinie 52 begrenzt. Ein Durchmesser D der Kreislinie 52 ist kleiner als eine erste Seitenlänge SL1 und kleiner als eine zweite Seitenlänge SL2 des Rechtecks des Substrats 11.

Die Mikrolinse 51 bündelt die elektromagnetische Strahlung S, sodass sie mit einer hohen Intensität in einer Richtung orthogonal zur Vorderseite 12 des Substrats 11 austritt. Das Substrat 11 enthält beispielsweise einen Nitrid-Verbindungshalbleiter, da in einen derartigen Verbindungshalbleiter eine Mikrolinse 51 mit geringem technischem Aufwand geätzt werden kann. Zum Ätzen wird ein Trockenätzverfahren eingesetzt.

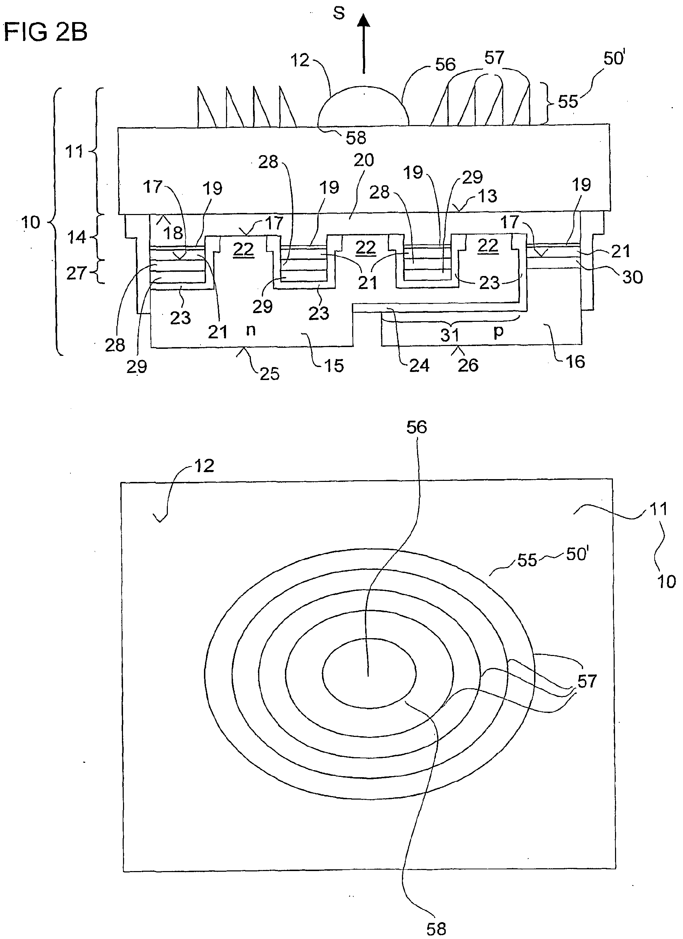

Gemäß Figur 2B umfasst die Auskoppelstruktur 50' ein diffraktives optisches Element 55, abgekürzt DOE. Das diffraktive optische Element 55 ist im Substrat 11 realisiert. Das diffraktive optische Element 55 umfasst eine Mikrolinse 56, um die herum mehrere Linien 57 angeordnet sind. Die Mikrolinse 56 weist eine elliptische Umrandung 58 auf. Entsprechend sind die Linien 57 als Ellipsen um die Mikrolinse 56 realisiert. Die Linien 57 weisen einen dreieckigen Querschnitt auf.

Mittels des diffraktiven optischen Elements 55 wird eine im Wesentlichen planare Struktur realisiert, welche die elektromagnetische Strahlung S in einer Richtung orthogonal zum Substrat 11 bündelt.

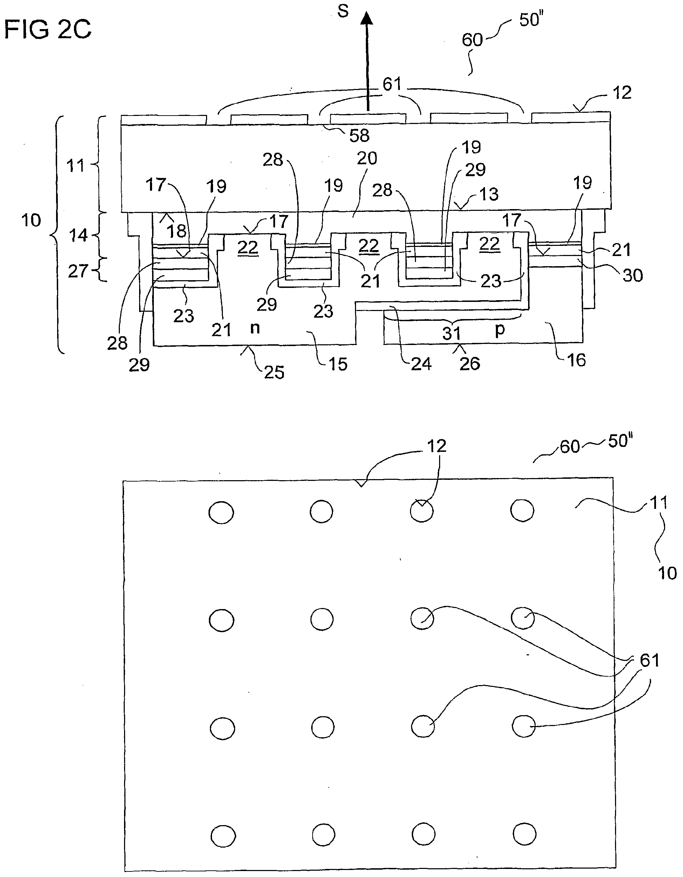

Gemäß Figur 2C ist die Auskoppelstruktur 50'' als photonischer Kristall 60, abgekürzt PhC, realisiert. Der photonische Kristall 60 ist im Substrat 11 ausgebildet. Dazu sind an der Vorderseite 12 Ausnehmungen 61 in das Substrat 11 geätzt. Die Ausnehmungen 61 sind in der Aufsicht kreisförmig ausgebildet. Die Ausnehmungen 61 sind regelmäßig angeordnet. Gemäß der in Figur 2C gezeigten Ausführungsform umfasst der photonische Kristall eine Anordnung von vier mal vier Ausnehmungen 61.

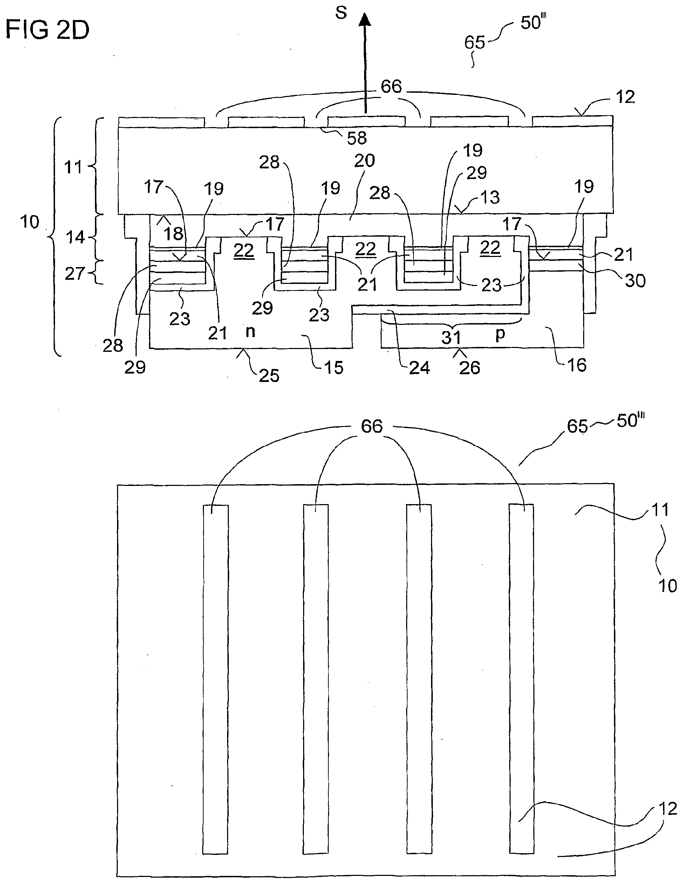

Gemäß Figur 2D ist die Auskoppelstruktur 50''' als Gitter 65 realisiert. Dazu sind streifenförmige Ausnehmungen 66 in das Substrat 11 geätzt. Die streifenförmigen Ausnehmungen 66 sind in der Aufsicht als Rechteck ausgebildet. Die streifenförmigen Ausnehmungen 66 sind zueinander parallel angeordnet. Das Gitter 65 ist somit im Substrat 11 ausgebildet.

Somit kann mittels des Gitters 65 eine Richtungsabhängigkeit der elektromagnetischen Strahlung S erzeugt werden.

Alternativ kann das Substrat den Hilfsträger 40 umfassen, der die jeweilige Auskoppelstruktur 50 aufweist. Gemäß dieser Ausführungsform ist die Auskoppelstruktur 50 im Hilfsträger 40 ausgebildet.

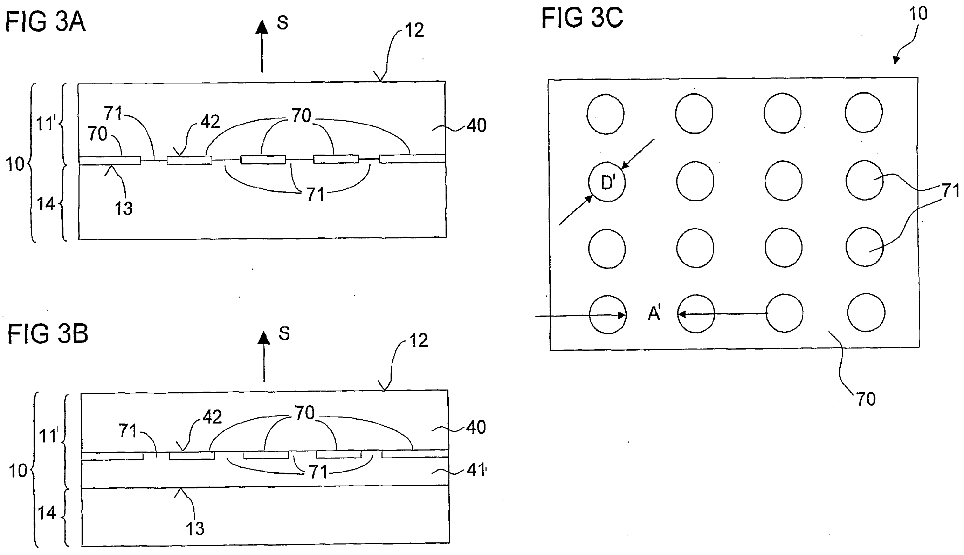

Figuren 3A bis 3C, 4A bis 4C und 5A bis 5C zeigen mehrere beispielhafte Ausführungsformen eines optoelektronischen Halbleiterkörpers, bei denen die Epitaxie strukturiert erfolgt, nach dem vorgeschlagenen Prinzip. Die in den Figuren gezeigten Ausführungsformen sind eine Weiterbildung der in Figur 1B dargestellten Ausführungsform. Das Substrat 11' umfasst somit den Hilfsträger 40. Der optoelektronische Halbleiterkörper 10 umfasst darüber hinaus die Halbleiterschichtenfolge 14, die erste und die zweite elektrische Anschlussschicht 15, 16, den Spiegel 27, die erste und die zweite Isolatorschicht 23, 24 sowie das transparente leitfähige Oxid 30 entsprechend den Figuren 1A und 1B. Die erste und die zweite elektrische Anschlussschicht 15, 16, der Spiegel 27, die erste und die zweite Isolatorschicht 23, 24 sowie das transparente leitfähige Oxid 30 sind aus Gründen der Übersichtlichkeit in den Figuren 3A bis 3C, 4A bis 4C und 5A bis 5C nicht dargestellt und wurden bereits anhand Figur 1A näher erläutert.

Figur 3A zeigt eine beispielhafte Ausführungsform eines optoelektronischen Halbleiterkörpers nach dem vorgeschlagenen Prinzip, bei dem das Substrat 11' eine Nukleationsschicht 70 aufweist. Die Nukleationsschicht 70 ist auf der ersten Hauptfläche 42 des Hilfsträgers 40 angeordnet. Somit ist die Nukleationsschicht 70 zwischen dem Hilfsträger 40 und der Halbleiterschichtenfolge 14 angeordnet. Die Nukleationsschicht 70 weist Strukturen, die als Ausnehmungen 71 ausgebildet sind, auf. Die Ausnehmungen 71 dienen zum Erzielen einer Strukturierung des Nukleationsschicht 70 und somit zur Durchführung einer strukturierten Epitaxie. Die Halbleiterschichtenfolge 14 ist auf der Nukleationsschicht 70 und an den Stellen, an denen die Nukleationsschicht 70 entfernt ist, auf dem Hilfsträger 40 abgeschieden. Die Nukleationsschicht 70 weist eine Dicke aus einem Intervall zwischen 1 nm und 1 µm auf. Eine typische Dicke der Nukleationsschicht 70 beträgt 25 nm. Die Nukleationsschicht 70 kann auch als Anwachsschicht bezeichnet werden. Die Nukleationsschicht 70 enthält einen Verbindungshalbleiter. Der Verbindungshalbleiter ist ein Nitrid-Verbindungshalbleiter. Der Verbindungshalbleiter kann beispielsweise Galliumnitrid oder Aluminiumnitrid sein. Die Nukleationsschicht 70 kann eine raue Oberfläche aufweisen.

Zur Herstellung des in Figur 3A gezeigten Querschnitts wird die Nukleationsschicht 70 auf dem Hilfsträger 40 abgeschieden. Anschließend wird in einem Fotolithografieschritt und einem Ätzschritt die Nukleationsschicht 70 strukturiert. Weiter erfolgt die epitaktische Abscheidung der Halbleiterschichtenfolge 14. Die Nukleationsschicht 70 erleichtert ein Aufwachsen der Halbleiterschichtenfolge 14 auf dem Hilfsträger 40.

Figur 3B zeigt eine alternative Ausführungsform des optoelektronischen Halbleiterkörpers. Im Unterschied zu Figur 3A weist das Substrat 11' zusätzlich die Pufferschicht 41 auf. Die Pufferschicht 41 ist auf der in Figur 3A gezeigten strukturierten Nukleationsschicht 70 beziehungsweise an den Stellen, an denen die Nukleationsschicht 70 entfernt ist, auf dem Hilfsträger 40 abgeschieden. Die Halbleiterschichtenfolge 14 wiederum ist auf der Pufferschicht 41 angeordnet. Gemäß dieser Ausführungsform dienen die strukturierte Nukleationsschicht 70 und die Pufferschicht 41 der Gitteranpassung zwischen dem Hilfsträger 40 und der Halbleiterschichtenfolge 14. Durch die Strukturierung der Nukleationsschicht 70 ist der Wellenleitereffekt am Übergang zwischen der Halbleiterschichtenfolge 14 und dem Hilfsträger 40 reduziert.

Zur Herstellung des in Figur 3B gezeigten Querschnitts wird die Nukleationsschicht 70 auf dem Hilfsträger 40 abgeschieden. Anschließend wird in einem Fotolithografieschritt und einem Ätzschritt die Nukleationsschicht 70 strukturiert. Es folgt die epitaktische Abscheidung der Pufferschicht 41 und weiter der Halbleiterschichtenfolge 14. Figur 3C zeigt eine beispielhafte Ausführungsform eines Querschnitts durch den in Figuren 3A und 3B gezeigten optoelektronischen Halbleiterkörper. In Figur 3C ist der Querschnitt durch die Nukleationsschicht 70 dargestellt. Die Nukleationsschicht 70 weist kreisförmige Ausnehmungen 71 auf. Die Ausnehmungen 71 haben einen Durchmesser D' aus einem Intervall zwischen 10 nm und 3 µm. Ein typischer Durchmesser D' der Ausnehmungen 71 beträgt 2 µm. Ein Abstand A' von einer Ausnehmung 71 zur nächsten Ausnehmung 71 kann einen Wert aus einem Intervall zwischen 20 nm und 10 µm aufweisen. Ein typischer Abstand A' hat den Wert 5 µm. Mit dem Abstand A', englisch pitch, ist der Abstand zwischen einem Rand einer Ausnehmung 71 und einem nächstliegenden Rand der nächstliegenden Ausnehmung 71 bezeichnet.

In alternativen Ausführungsformen weisen die Ausnehmungen 71 hexagonale Strukturen oder andere geometrische Strukturen auf.

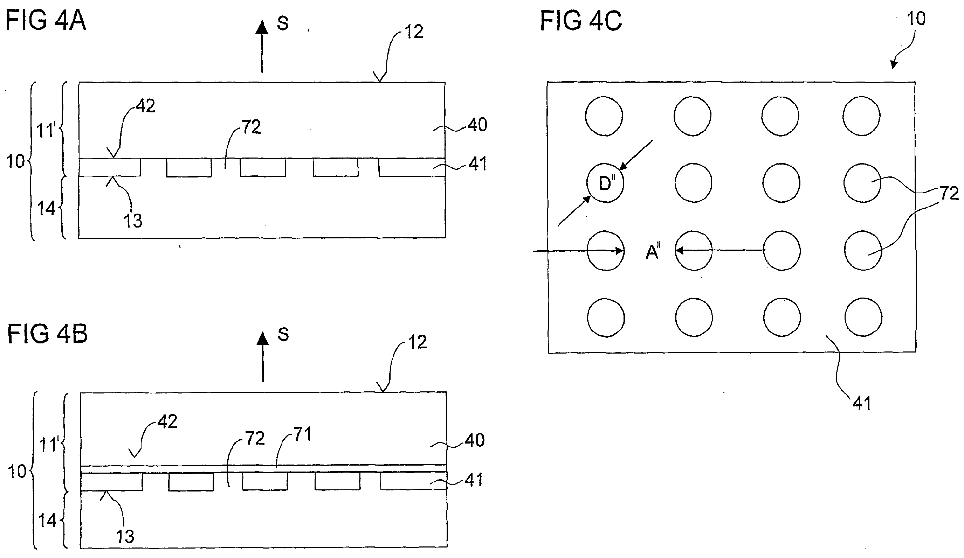

Figur 4A zeigt eine beispielhafte Ausführungsform eines optoelektronischen Halbleiterkörpers nach dem vorgeschlagenen Prinzip mit einer strukturierten Pufferschicht 41. Die Pufferschicht 41 ist auf der ersten Hauptfläche 42 des Hilfsträgers 40 angeordnet. Die Pufferschicht 41 weist Strukturen, die als Ausnehmungen 72 ausgebildet sind, auf. Die Ausnehmungen 72 dienen zum Erzielen einer Strukturierung der Pufferschicht 41 und somit zur Durchführung einer strukturierten Epitaxie. Die Halbleiterschichtenfolge 14 ist auf der Pufferschicht 41 und an den Stellen, an denen die Pufferschicht 41 entfernt ist, auf dem Hilfsträger 40 abgeschieden.

Zur Herstellung des in Figur 4A gezeigten Querschnittes wird die Pufferschicht 41 auf dem Hilfsträger 40 abgeschieden. In einem Fotolithografie- und in einem Ätzschritt wird die Pufferschicht 41 zur Ausbildung der Ausnehmungen 72 strukturiert. Anschließend erfolgt das epitaktische Abscheiden der Halbleiterschichtenfolge 14. Die Dicke der Pufferschicht 41 hat einen Wert aus dem Intervall zwischen 0,5 µm und 8 µm. Ein typischer Wert der Dicke der Pufferschicht 41 ist 3 µm.

Figur 4B zeigt eine beispielhafte Ausführungsform eines optoelektronischen Halbleiterkörpers, welcher eine Weiterbildung der in Figur 4A gezeigten Ausführungsform ist. Gemäß Figur 4B weist das Substrat 11' zusätzlich die Nukleationsschicht 70 auf. Die Nukleationsschicht 70 ist auf der ersten Hauptfläche 42 des Hilfsträgers 40 abgeschieden. Somit befindet sich die Nukleationsschicht 70 zwischen dem Hilfsträger 40 und der Pufferschicht 41. Die Halbleiterschichtenfolge 14 ist wiederum auf der Pufferschicht 41 beziehungsweise an den Stellen, an denen die Pufferschicht 41 strukturiert ist, auf der Nukleationsschicht 70 abgeschieden.

Zur Realisierung des in Figur 4B gezeigten Querschnitts wird die Nukleationsschicht 70 auf den Hilfsträger 40 und anschließend die Pufferschicht 41 auf der Nukleationsschicht 70 abgeschieden. Der Abscheideprozess der Pufferschicht 41 erfolgt epitaktisch. Anschließend wird die Pufferschicht 41 in einem Fotolithografieschritt und einem Ätzschritt zur Herstellung der Ausnehmungen 72 strukturiert. Daraufhin erfolgt das epitaktische Abscheiden der Halbleiterschichtenfolge 14.

Figur 4C zeigt einen Querschnitt durch den in Figur 4A beziehungsweise Figur 4B gezeigten optoelektronischen Halbleiterkörper. In Figur 4C ist ein Querschnitt durch die Pufferschicht 41 gezeigt. Die Pufferschicht 41 weist kreisförmige Ausnehmungen 72 auf. Ein Durchmesser D'' der Ausnehmungen 72 hat einen Wert aus einem Intervall zwischen 80 nm und 3 µm. Ein typischer Wert für den Durchmesser D'' beträgt 2 µm. Ein Abstand A'' zwischen zwei Ausnehmungen hat einen Wert aus einem Intervall zwischen 120 nm und 10 µm. Ein typischer Wert für den Abstand A'' beträgt 5 µm.

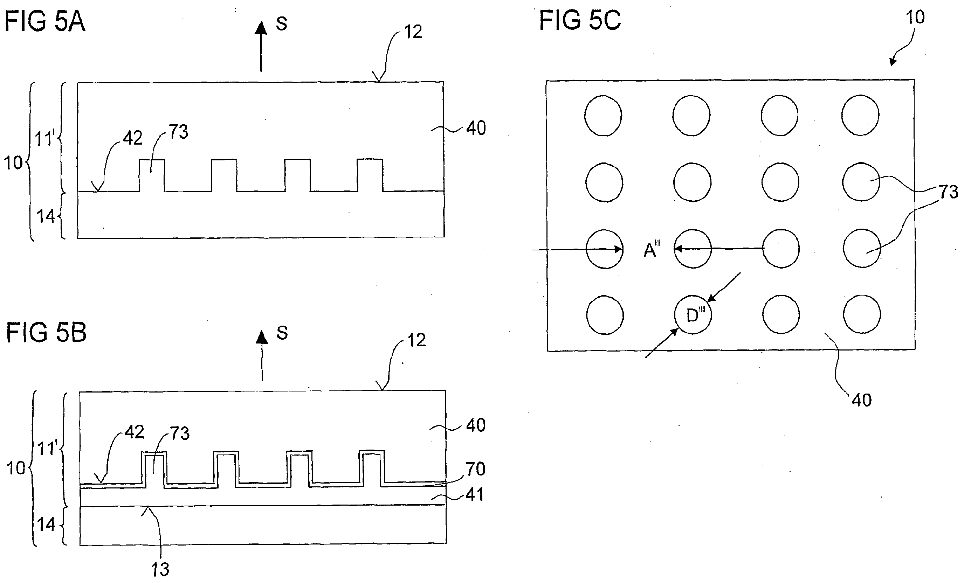

Figur 5A zeigt eine beispielhafte Ausführungsform eines optoelektronischen Halbleiterkörpers nach dem vorgeschlagenen Prinzip mit einem strukturierten Substrat. Dabei weist der Hilfsträger 40 des Substrates 11' Strukturen, die als Ausnehmungen 73 ausgebildet sind, auf. Der Hilfsträger 40 weist Ausnehmungen 73 an der ersten Hauptfläche 42 auf. Die Ausnehmungen 73 haben eine Tiefe aus einem Intervall zwischen 10 nm bis 2 µm. Ein typischer Wert für die Tiefe der Ausnehmungen 73 ist 500 nm. Die Ausnehmungen 73 dienen zum Erzielen einer Strukturierung des Hilfsträgers 40 und somit zur Durchführung einer strukturierten Epitaxie. Auf dem Hilfsträger 40 ist die Halbleiterschichtenfolge 14 abgeschieden. Zur Herstellung des in Figur 5A gezeigten Querschnittes wird der Hilfsträger 41 mittels eines Fotolithografieschrittes und eines Ätzschrittes strukturiert. Daraufhin wird die Halbleiterschichtenfolge 14 abgeschieden.

Figur 5B zeigt eine alternative Ausführungsform eines optoelektronischen Halbleiterkörpers, welche eine Weiterbildung der in Figur 5A gezeigten Ausführungsform ist. Gemäß Figur 5B umfasst das Substrat 11' den Hilfsträger 40, der strukturiert ist, die Nukleationsschicht 70 sowie die Pufferschicht 41. Dabei ist auf dem Hilfsträger 40 die Nukleationsschicht 70 und auf der Nukleationsschicht 70 die Pufferschicht 41 angeordnet.

Um den in Figur 5B dargestellten Querschnitt zu realisieren, wird der Hilfsträger 40 mittels eines Fotolithografieschrittes und eines Ätzprozesses zur Herstellung der Ausnehmungen 73 strukturiert. Anschließend wird die Nukleationsschicht 70 in einer Epitaxieanlage auf dem Hilfsträger 40 abgeschieden. Daraufhin wird die Pufferschicht 41 auf der Nukleationsschicht 70 sowie die Halbleiterschichtenfolge 14 auf der Pufferschicht 41 epitaktisch abgeschieden. In einer Ausführungsform des Verfahrens kann die Abscheidung der Nukleationsschicht 70 wie auch der Pufferschicht 41 und der Halbleiterschichtenfolge 14 ohne Vakuumunterbrechung durchgeführt werden, so dass eine hohe Güte der Schichten erzielt wird.

In einer alternativen, nicht gezeigten Ausführungsform kann die Nukleationsschicht 70 entfallen, so dass die Pufferschicht 41 direkt auf dem Hilfsträger 40 abgeschieden wird.

Figur 5C zeigt eine beispielhafte Ausführungsform eines Querschnitts durch den in Figur 5A beziehungsweise 5B dargestellten optoelektronischen Halbleiterkörper. Es ist ein Querschnitt durch den Hilfsträger 40 gezeigt. Der Hilfsträger 40 weist kreisförmige Ausnehmungen 73 auf. Die Ausnehmungen 73 weisen einen Durchmesser D''' aus einem Intervall zwischen 80 nm und 3 µm auf. Ein typischer Wert für einen Durchmesser D''' beträgt 2 µm. Ein Abstand A''' zwischen zwei Ausnehmungen 73 hat einen Wert aus einem Intervall zwischen 120 nm und 10 µm. Ein typischer Wert für den Abstand A''' beträgt 5 µm.

In alternativen Ausführungsformen weisen die Ausnehmungen 73 hexagonale Strukturen oder andere geometrische Strukturen auf.

Gemäß den Figuren 3A bis 3C, 4A bis 4C und 5A bis 5C wird aufgrund der Strukturierung der Nukleationsschicht 70 oder der Pufferschicht 41 oder des Hilfsträgers 40 ein Wellenleitereffekt zwischen dem Hilfsträger 40 und der Halbleiterschichtenfolge 14 verringert. Die Nukleationsschicht 70 und/oder die Pufferschicht 41 erleichtern eine Gitteranpassung zwischen dem Hilfsträger 40 und der Halbleiterschichtenfolge 14. Die Ausnehmungen 71 in der Nukleationsschicht 70 beziehungsweise die Ausnehmungen 72 in der Pufferschicht 41 beziehungsweise die Ausnehmungen 73 in dem Hilfsträger 40 werden von der Halbleiterschichtenfolge 14 epitaktisch überwachsen.

Das Abscheiden der Nukleationsschicht 70 kann in einer Epitaxieanlage erfolgen. Ebenso kann das Abscheiden der Pufferschicht 41 in einer Epitaxieanlage erfolgen.

Mittels der Strukturierung der Nukleationsschicht 70, der Pufferschicht 41 oder dem Hilfsträger 40 kann die Wirkung eines photonischen Kristalls erzielt werden.

## Patentansprüche

1. Optoelektronischer Halbleiterkörper, umfassend
- ein Substrat (11) mit einer Vorderseite (12) zur Emission von elektromagnetischer Strahlung (S),
- eine Halbleiterschichtenfolge (14), die auf einer Rückseite (13) des Substrats (11) angeordnet ist und eine zur Erzeugung der elektromagnetischen Strahlung (S) geeignete aktive Schicht (19) aufweist,
- eine erste und eine zweite elektrische Anschlussschicht (15, 16), die auf einer vom Substrat (11) abgewandten ersten Fläche (17) der Halbleiterschichtenfolge (14) angeordnet sind,
dadurch gekennzeinchnet dass der optoelektronische Halbleiterkörper
- einen Spiegel (27) umfasst, der zur Spiegelung eines Anteils der von der aktiven Schicht (19) erzeugten elektromagnetischen Strahlung (S) an der vom Substrat (11, 11') abgewandten ersten Fläche (17) der Halbleiterschichtenfolge (14) bereichsweise angeordnet ist, wobei der Spiegel (27) zumindest eine Ausnehmung (22) aufweist und die erste elektrische Anschlussschicht (15) in der zumindest einen Ausnehmung (22) einen elektrisch leitenden Kontakt zu der Halbleiterschichtenfolge (14) aufweist.

2. Optoelektronischer Halbleiterkörper nach Anspruch 1, bei dem das Substrat (11) und die Halbleiterschichtenfolge (14) einen Nitrid-Verbindungshalbleiter enthalten.

3. Optoelektronischer Halbleiterkörper nach Anspruch 2, bei dem das Substrat (11) kristallines Galliumnitrid enthält.

4. Optoelektronischer Halbleiterkörper nach Anspruch 1, bei dem das Substrat (11') einen Hilfsträger (40), der vorderseitig im Substrat (11') angeordnet ist, umfasst und die Halbleiterschichtenfolge (14) einen Nitrid-Verbindungshalbleiter enthält, der auf der Rückseite (13) des Substrats (11') angeordnet ist.

5. Optoelektronischer Halbleiterkörper nach Anspruch 4, bei dem der Hilfsträger (40) kristallines Aluminiumoxid enthält.

6. Optoelektronischer Halbleiterkörper nach einem der Ansprüche 4 oder 5,
bei dem eine der Halbleiterschichtenfolge (14) zugewandte erste Hauptfläche (42) des Hilfsträgers (40) strukturiert ist.

7. Optoelektronischer Halbleiterkörper nach einem der Ansprüche 4 bis 6,
bei dem das Substrat (11') eine Nukleationsschicht (70) umfasst, die auf einer der Halbleiterschichtenfolge (14) zugewandten ersten Hauptfläche (42) des Hilfsträgers (40) angeordnet ist.

8. Optoelektronischer Halbleiterkörper nach Anspruch 7, bei dem die Nukleationsschicht (70) strukturiert ist.

9. Optoelektronischer Halbleiterkörper nach einem der Ansprüche 4 bis 8,
bei dem das Substrat (11') eine Pufferschicht (41) umfasst, die auf einer der Halbleiterschichtenfolge (14) zugewandten ersten Hauptfläche (42) des Hilfsträgers (40) oder einer auf der ersten Hauptfläche (42) des Hilfsträgers (40) angeordneten Nukleationsschicht (70) angeordnet ist.

10. Optoelektronischer Halbleiterkörper nach Anspruch 9, bei dem die Pufferschicht (41) strukturiert ist.

11. Optoelektronischer Halbleiterkörper nach einem der vorhergehenden Ansprüche,
bei dem die Emission der elektromagnetischen Strahlung (S) von der Vorderseite (12) des Substrats (11, 11') durch eine Auskoppelstruktur (50) hindurch erfolgt.

12. Optoelektronischer Halbleiterkörper nach Anspruch 11, bei dem die Auskoppelstruktur (50, 50', 50'', 50''') eine Mikrolinse (51), ein diffraktives optisches Element (55), einen photonischen Kristall (60) oder ein Gitter (65) umfasst.

13. Optoelektronischer Halbleiterkörper nach einem der vorhergehenden Ansprüche,
bei dem der Spiegel (27) eine dielektrische Schicht (28) und eine Metallschicht (29) umfasst.

## Claims

1. Optoelectronic semiconductor body, comprising
- a substrate (11) having a front side (12) for emitting electromagnetic radiation (S),
- a semiconductor layer sequence (14) arranged on a rear side (13) of the substrate (11) and having an active layer (19) suitable for generating the electromagnetic radiation (S),
- a first and a second electrical connection layer (15, 16) arranged on a first surface (17) of the semiconductor layer sequence (14) facing away from the substrate (11),
**characterized in that** the optoelectronic semiconductor body comprises
a mirror (27) arranged regionally for the purpose of reflecting a portion of the electromagnetic radiation (S) generated by the active layer (19) at the first surface (17) of the semiconductor layer sequence (14) facing away from the substrate (11, 11'), wherein the mirror (27) has at least one cutout (22) and the first electrical connection layer (15) in the at least one cutout (22) has an electrically conductive contact with the semiconductor layer sequence (14).

2. Optoelectronic semiconductor body according to claim 1,
wherein the substrate (11) and the semiconductor layer sequence (14) contain a nitride compound semiconductor.

3. Optoelectronic semiconductor body according to claim 2,
wherein the substrate (11) contains crystalline gallium nitride.

4. Optoelectronic semiconductor body according to claim 1,
wherein the substrate (11') comprises an auxiliary carrier (40) arranged on the front side in the substrate (11'), and the semiconductor layer sequence (14) contains a nitride compound semiconductor arranged on the rear side (13) of the substrate (11').

5. Optoelectronic semiconductor body according to claim 4,
wherein the auxiliary carrier (40) contains crystalline aluminium oxide.

6. Optoelectronic semiconductor body according to either of claims 4 and 5,
wherein a first main surface (42) of the auxiliary carrier (40) facing the semiconductor layer sequence (14) is structured.

7. Optoelectronic semiconductor body according to any of claims 4 to 6,
wherein the substrate (11') comprises a nucleation layer (70) arranged on a first main surface (42) of the auxiliary carrier (40) facing the semiconductor layer sequence (14).

8. Optoelectronic semiconductor body according to claim 7,
wherein the nucleation layer (70) is structured.

9. Optoelectronic semiconductor body according to any of claims 4 to 8,
wherein the substrate (11') comprises a buffer layer (41) arranged on a first main surface (42) of the auxiliary carrier (40) facing the semiconductor layer sequence (14), or on a nucleation layer (70) arranged on the first main surface (42) of the auxiliary carrier (40).

10. Optoelectronic semiconductor body according to claim 9,
wherein the buffer layer (41) is structured.

11. Optoelectronic semiconductor body according to any of the preceding claims,
wherein the electromagnetic radiation (S) is emitted from the front side (12) of the substrate (11, 11') through a coupling-out structure (50).

12. Optoelectronic semiconductor body according to claim 11,
wherein the coupling-out structure (50, 50', 50'', 50''') comprises a microlens (51), a diffractive optical element (55), a photonic crystal (60) or a grating (65).

13. Optoelectronic semiconductor body according to any of the preceding claims,
wherein the mirror (27) comprises a dielectric layer (28) and a metal layer (29).

## Revendications

1. Corps semiconducteur optoélectronique, comprenant
- un substrat (11) muni d'un côté avant (12) servant à l'émission d'un rayonnement électromagnétique (S),
- une séquence de couches semiconductrices (14) qui est disposée sur un côté arrière (13) du substrat (11) et possède une couche active (19) adaptée pour générer le rayonnement électromagnétique (S),
- des première et deuxième couches de raccordement (15, 16) électriques qui sont disposées sur une première surface (17) de la séquence de couches semiconductrices (14) à l'opposé du substrat (11),
**caractérisé en ce que** le corps semiconducteur optoélectronique comprend un miroir (27) qui, en vue de réfléchir une part du rayonnement électromagnétique (S) généré par la couche active (19), est disposé dans certaines zones sur la première surface (17) à l'opposé du substrat (11, 11') de la séquence de couches semiconductrices (14), le miroir (27) possédant au moins une cavité (22) et la première couche de raccordement (15) électrique possédant dans l'au moins une cavité (22) un contact électriquement conducteur avec la séquence de couches semiconductrices (14).

2. Corps semiconducteur optoélectronique selon la revendication 1, avec lequel le substrat (11) et la séquence de couches semiconductrices (14) contiennent un semiconducteur à base de composé de nitrure.

3. Corps semiconducteur optoélectronique selon la revendication 2, avec lequel le substrat (11) contient du nitrure de gallium.

4. Corps semiconducteur optoélectronique selon la revendication 1, avec lequel le substrat (11') comprend un support auxiliaire (40) qui est disposé du côté avant du substrat (11') et la séquence de couches semiconductrices (14) contient un semiconducteur à base de composé de nitrure qui est disposé sur le côté arrière (13) du substrat (11').

5. Corps semiconducteur optoélectronique selon la revendication 4, avec lequel le support auxiliaire (40) contient de l'oxyde d'aluminium cristallin.

6. Corps semiconducteur optoélectronique selon l'une des revendications 4 ou 5, avec lequel une première surface principale (42) du support auxiliaire (40) qui fait face à la séquence de couches semiconductrices (14) est structurée.

7. Corps semiconducteur optoélectronique selon l'une des revendications 4 à 6, avec lequel le substrat (11') comprend une couche de nucléation (70) qui est disposée sur une première surface principale (42) du support auxiliaire (40) qui fait face à la séquence de couches semiconductrices (14).

8. Corps semiconducteur optoélectronique selon la revendication 7, avec lequel la couche de nucléation (70) est structurée.

9. Corps semiconducteur optoélectronique selon l'une des revendications 4 à 8, avec lequel le substrat (11') comprend une couche tampon (41) qui est disposée sur une première surface principale (42) du support auxiliaire (40) qui fait face à la séquence de couches semiconductrices (14) ou sur une couche de nucléation (70) disposée sur la première surface principale (42) du support auxiliaire (40).

10. Corps semiconducteur optoélectronique selon la revendication 9, avec lequel la couche tampon (41) est structurée.

11. Corps semiconducteur optoélectronique selon l'une des revendications précédentes, avec lequel l'émission du rayonnement électromagnétique (S) depuis le côté avant (12) du substrat (11, 11') s'effectue à travers une structure de découplage (50).

12. Corps semiconducteur optoélectronique selon la revendication 11, avec lequel la structure de découplage (50, 50', 50'', 50''') comprend une microlentille (51), un élément optique diffractif (55), un cristal photonique (60) ou une grille (65).

13. Corps semiconducteur optoélectronique selon l'une des revendications précédentes, avec lequel le miroir (27) comprend une couche diélectrique (28) et une couche métallique (29).
